# EUROPEAN PATENT APPLICATION

(11) **EP 2 479 833 A1**
(43) Date of publication of application: **25.07.2012**
(21) Application number: 10798246.4
(22) Date of filing: 20.05.2010
(51) Int. Cl.: H01M 10/44, G01R 31/36, H01M 10/48, H02J 7/04

(54) **NONAQUEOUS ELECTROLYTE SECONDARY BATTERY CHARGING METHOD AND CHARGING DEVICE**

(30) Priority: 18.09.2009 JP 2009216445
(71) Applicant: Panasonic Corporation, Kadoma-shi Osaka 571-8501 (JP)
(72) Inventor: DEGUCHI, Masaki, (JP); UGAJI, Masaya, (JP)
(74) Representative: TBK
(86) International application number: PCT/JP2010/003390
(87) International publication number: WO 2011/033700

(57) **Abstract**

In a charging method for a non-aqueous electrolyte secondary battery which comprises a positive electrode including a lithium-containing composite oxide as an active material, a negative electrode induding a material capable of charging and discharging lithium ions as an active material, and a non-aqueous electrolyte, an open circuit voltage of the secondary battery is detected. When the detected value is smaller than a predetermined voltage x, charging is performed at a comparatively small current value B. When the detected value is equal to or greater than the predetermined voltage x and smaller than a predetermined voltage z, charging is performed at a comparatively great current value A. When the detected value is equal to or greater than the predetermined voltage z and smaller than a predetermined voltage y, charging is performed at a comparatively small current value C. When the detected value is greater than the predetermined voltage y, constant-voltage charging is performed or charging is terminated. Here, x<z<y.

## Description

### [Technical Field]

The present invention relates to a charging method and a charger for a non-aqueous electrolyte secondary battery which comprises a positive electrode including a lithium-containing composite oxide as an active material, a negative electrode including a material capable of charging and discharging lithium ions as an active material, and a non-aqueous electrolyte.

### [Background Art]

Secondary batteries including a non-aqueous electrolyte (i.e., non-aqueous electrolyte secondary batteries) such as lithium ion secondary batteries are generally charged by a method of constant-current and constant-voltage charging. In constant-current and constant-voltage charging, charging is performed at a constant current until the battery voltage reaches a predetermined voltage. After the battery voltage has reached the predetermined voltage, the charge current is reduced so that the battery voltage is maintained at the predetermined voltage. When the charge current is reduced to a predetermined value, charging is terminated.

With regard to constant-current and constant-voltage charging, Patent Literature 1 discloses the following technique.
In constant-current and constant-voltage charging, if the charge cutoff voltage of a battery is set high, the decomposition of the electrolyte on the positive electrode and the destruction of crystals of the positive electrode active material are accelerated, and the cycle characteristics deteriorate. In order to avoid this, charging is performed at a large current at the beginning of charging. The charge current is reduced immediately after the battery voltage has reached a charge cutoff voltage. By reducing the charge current, the battery voltage is reduced. When the battery voltage reaches the charge cut-off voltage again, the charge current is further reduced. These procedures are repeated. In such a manner, charging is performed at a large current at the beginning of charging, and then the charge current is reduced stepwise.

Patent Literature 2 proposes the following technique.
Charging is performed at an allowable maximum current at the beginning of charging in order to rapidly achieve a full charge. Charging is paused when the battery voltage reaches a charge cutoff voltage. After an interval for a predetermined period of time, charging is resumed at a current smaller than that before the interval.

### [Citation List]

### [Patent Literature]

[PTL 1] Japanese Laid-Open Patent Publication No. Hei 7-296853
[PTL 2] Japanese Laid-Open Patent Publication No. 2007-311107

### [Summary of Invention]

### [Technical Problem]

In Patent Literatures 1 and 2, in order to improve the cycle characteristics or to shorten the charging time, constant-current charging is performed in such a manner that charging is started with a large charge current and then the charge current is reduced. However, there is no sufficient theoretical basis for how the controlling of the charge current as disclosed in Patent Literature 1 can improve the cycle characteristics of a secondary battery.

The present inventors have conducted detailed analysis on the relationship between a state of charge (SOC) and an intemal resistance of a secondary battery, by the GITT (Galvanostatic Intermittent Titration Technique) method. As a result, the inventors have found that when the above-described conventional techniques are applied, there is a possibility that the charge polarization greatly varies in association with the state of charge, which, contrary to the intended purpose, causes the cycle characteristics of the secondary battery to deteriorate.

On the basis of the foregoing new findings on the relationship between the state of charge and the intemal resistance, the present invention intends to provide a charging method and a charger for a non-aqueous electrolyte secondary battery that can improve the characteristics relating to service life of a non-aqueous electrolyte secondary battery.

### [Solution to Problem]

One aspect of the present invention is a charging method for a non-aqueous electrolyte secondary battery which comprises a positive electrode including a lithium-containing composite oxide as an active material, a negative electrode including a material capable of charging and discharging lithium ions as an active material, and a non-aqueous electrolyte, the charging method comprising the steps of:
(a) detecting a state of charge of the secondary battery;
(b) comparing the detected state of charge with a predetermined value X and a predetermined value Y satisfying Y>X; and
(c) on the basis of the comparison result,
   (i) when the detected state of charge is equal to or higher than the predetermined value Y, performing constant-voltage charging or terminating charging,
   (ii) when the detected state of charge is equal to or higher than the predetermined value X and lower than the predetermined value Y, performing constant-current charging at a current value A until the detected state of charge reaches a predetermined state of charge, and
   (iii) when the detected state of charge is lower than the predetermined value X, performing constant-current charging at a current value B satisfying B<A.

Another aspect of the present invention is a charger for a non-aqueous electrolyte secondary battery which comprises a positive electrode including a lithium-containing composite oxide as an active material, a negative electrode including a material capable of charging and discharging lithium ions as an active material, and a non-aqueous electrolyte, the charger comprising:
a voltage detection unit for detecting a voltage of the secondary battery;
a state-of-charge detection unit for detecting a state of charge of the secondary battery on the basis of the detected voltage;
a current supply circuit for supplying a current from an external or internal DC power supply to the secondary battery with changing a value of the current stepwise;
a switch for switching an electrically connected state between the secondary battery and the current supply circuit;
a judgment unit for comparing the detected state of charge with a predetermined value X and a predetermined value Y satisfying Y>X, to make judgment on the detected state of charge; and
a control unit for controlling the switch and the current supply circuit on the basis of the judgment of the judgment unit, in such a manner that
   (i) when the detected state of charge is equal to or higher than the predetermined value Y, performing constant-voltage charging or terminating charging,
   (ii) when the detected state of charge is equal to or higher than the predetermined value X and lower than the predetermined value Y, performing constant-current charging at a current value A until the detected state of charge reaches a predetermined state of charge, and
   (iii) when the detected state of charge is lower than the predetermined value X, performing constant-current charging at a current value B satisfying B<A.

### [Advantageous Effects of Invention]

According to the present invention, the characteristics relating to service life of a non-aqueous electrolyte secondary battery can be improved.

While the novel features of the invention are set forth particularly in the appended claims, the invention, both as to organization and content, will be better understood and appreciated, along with other objects and features thereof, from the following detailed description taken in conjunction with the drawings.

### [Brief Description of Drawings]

Fig. 1 is a flowchart of a charging method for a non-aqueous electrolyte secondary battery according to one embodiment of the present invention.
Fig. 2 is a block diagram showing a schematic configuration of a charger for a non-aqueous electrolyte secondary battery to which the charging method shown in Fig. 1 is applied.
Fig. 3 is a diagram schematically showing segmentation of regions of battery voltage determined by the method shown in Fig.1.
Fig. 4 is a graph showing one example of the relationship between an intemal resistance in a secondary battery and a charge current, when the secondary battery is charged by the method shown in Fig. 1.
Fig. 5 is a graph showing one example of a charging method employed when the intemal resistance characteristics relative to the state of charge of a secondary battery is analyzed by the GITR method.
Fig. 6 is a flowchart for explaining a charging method for two or more non-aqueous electrolyte secondary batteries according to another embodiment of the present invention.
Fig. 7 is a flowchart for explaining a charging method for two or more non-aqueous electrolyte secondary batteries according to still another embodiment of the present invention.
Fig. 8 is a block diagram showing a schematic configuration of a charger for a non-aqueous electrolyte secondary battery to which the charging method shown in Figs. 6 and 7 are applied.

### [Description of Embodiments]

A charging method for a non-aqueous electrolyte secondary battery according to one embodiment of the present invention is a method for charging a non-aqueous electrolyte secondary battery which comprises a positive electrode including a lithium-containing composite oxide as an active material, a negative electrode including a material capable of charging and discharging lithium ions as an active material, and a non-aqueous eledrolyte.

This charging method indudes the steps of: (a) detecting a state of charge of the secondary battery; (b) comparing the detected state of charge with a predetermined value X and a predetermined value Y satisfying Y>X; and (c) on the basis of the comparison results, (i) when the detected state of charge is equal to or higher than the predetermined value Y, performing constant-voltage charging or terminating charging, (ii) when the detected state of charge is equal to or higher than the predetermined value X and lower than the predetermined value Y, performing constant-current charging at a current value A until the detected state of charge reaches a predetermined state of charge, and (ii) when the detected state of charge is lower than the predetermined value X, performing constant-current charging at a current value B satisfying B<A.

As described above, in the charging method for a non-aqueous electrolyte secondary battery according to one embodiment of the present invention, at the beginning of charging when the battery is nearly in a fully discharged state, charging is performed at the current value B, which is comparatively small, and then, after the state of charge is increased to a certain extent, charging is performed at the current value A, which is comparatively great.

The present inventors have conducted analysis on the relationship between a state of charge and an intemal resistance of a secondary battery by the GITT method. As a result, the inventors have found that in a secondary battery using a positive electrode including a lithium-containing composite oxide, the intemal resistance of the battery is extremely high when the state of charge is low, but the intemal resistance drops sharply when the state of charge is increased to a certain extent. This means that if the battery is charged at a constant current from the beginning of charge when the state of charge is low to the end of charge when the battery is fully charged, the charge polarization greatly varies as the internal resistance varies, causing charging irregularity (non-uniform charging). As a result, for example, the negative electrode active material layer anisotropically expands to cause a separation of the solid electrolyte interphase (SEI) from the negative electrode, or the decomposition of the electrolyte and the generation of reducing gas inside the battery are accelerated, and consequently, the cycle characteristics of the non-aqueous electrolyte secondary battery deteriorate.

However, by charging a secondary battery at a comparatively small current value B at the beginning of charging when the internal resistance in the secondary battery is high, and then charging the secondary battery at a comparatively great current value A after the intemal resistance in the secondary battery has been reduced, the charge polarization can be prevented from varying greatly. This makes it possible to suppress the charging irregularity, and thus to improve the cycle characteristics of the non-aqueous electrolyte secondary battery.

A charging method for a non-aqueous electrolyte secondary battery according to another embodiment of the present invention further indudes (d) comparing the detected state of charge with a predetermined value Z satisfying Y>Z>X, and when the detected state of charge is equal to or higher than the predetermined value Z and lower than the predetermined value Y, performing constant-current charging at a current value C satisfying C<A.

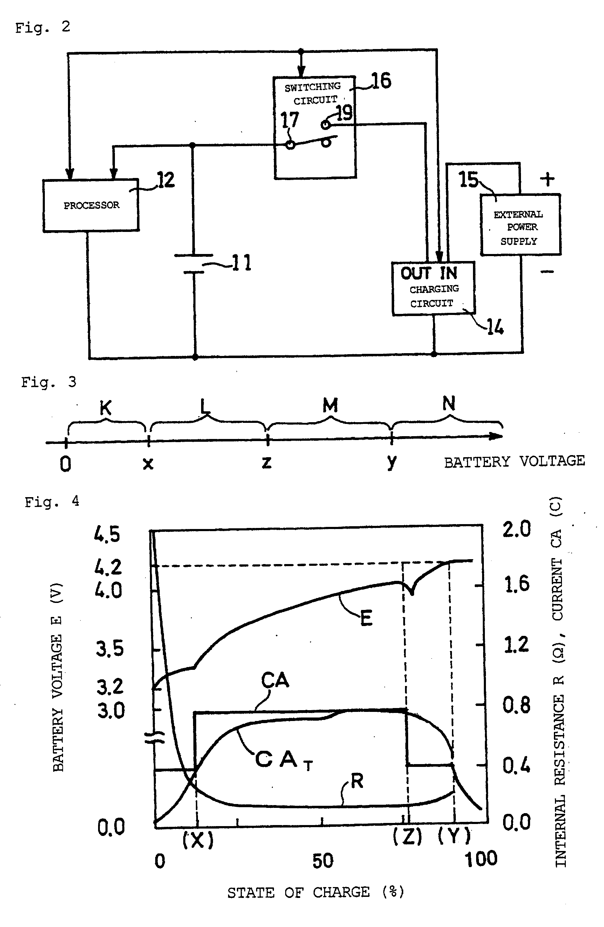

As described above, the internal resistance of a secondary battery is extremely high when the state of charge is low, and drops sharply when the state of charge becomes high. However, when the state of charge becomes higher than a certain level, the intemal resistance of the secondary battery which has dropped starts increasing again as shown in Fig. 4. As such, by charging at a current value C smaller than the current value A while the state of charge is higher than a certain level, the variation in charge polarization can be minimized. This can further improve the cycle characteristics of the non-aqueous electrolyte secondary battery.

The state of charge of a secondary battery can be measured by detecting an open circuit voltage or a dosed drcuit voltage of the secondary battery. The predetermined value X is preferably set at a state of charge of 5 to 30%, and the predetermined value Z is preferably set at a state of charge of 65 to 90%. The current value B is preferably set to 10 to 60% of the current value A, and the current value C is also preferably set to 10 to 60% of the current value A.

A charger for a non-aqueous electrolyte secondary battery according one embodiment of the present invention is a charger for charging a non-aqueous electrolyte secondary battery which comprises a positive electrode including a lithium-containing composite oxide as an active material, a negative electrode including a material capable of charging and discharging lithium ions as an active material, and a non-aqueous electrolyte.

This charger includes: a voltage detection unit for detecting a voltage of the secondary battery; a state-of-charge detection unit for detecting a state of charge of the secondary battery on the basis of the detected voltage; a current supply circuit for supplying a current from an external or internal DC power supply to the secondary battery with changing a value of the current stepwise; a switch for switching an electrically connected state between the secondary battery and the current supply circuit; a judgment unit for comparing the detected state of charge with a predetermined value X and a predetermined value Y satisfying Y>X, to make judgment on the detected state of charge, and a control unit. The control unit is configured to control the switch and the current supply circuit on the basis of the judgment of the judgment unit, in such a manner that: (i) when the detected state of charge is equal to or higher than the predetermined value Y, performing constant-voltage charging or terminating charging; (ii) when the detected state of charge is equal to or higher than the predetermined value X and lower than the predetermined value Y, performing constant-current charging at a current value A until the detected state of charge reaches a predetermined state of charge; and (iii) when the detected state of charge is lower than the predetermined value X, performing constant-current charging at a current value B satisfying B<A.

Embodiments of the present invention are described below with reference to the drawings.

### (Embodiment 1)

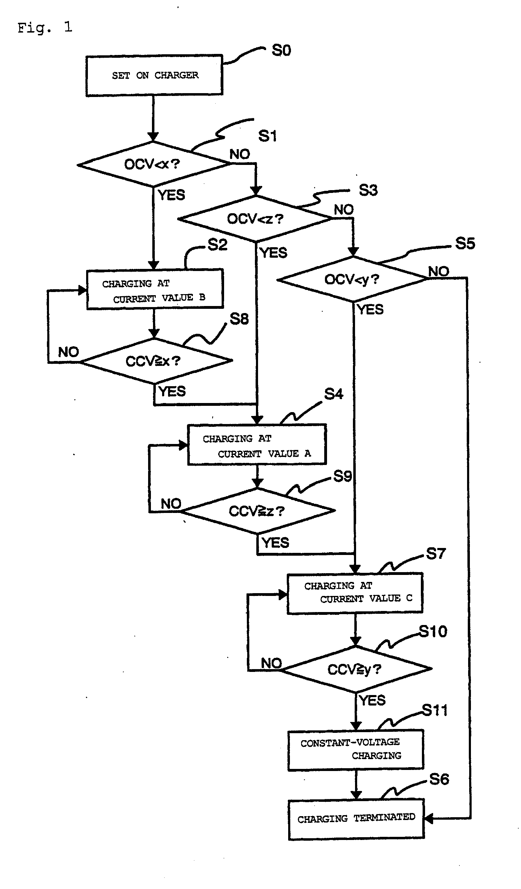

Fig. 1 is a flowchart of a charging method for a non-aqueous electrolyte secondary battery according to one embodiment of the present invention. Fig. 2 is a block diagram showing a schematic configuration of an example of a charger to which the charging method shown in Fig. 1 is applied.

The charger indudes a processor 12, a charging circuit 14, and a switching circuit 16. A non-aqueous electrolyte secondary battery (hereinafter simply referred to as a "battery") 11 is set on the charger and is connected in parallel with the processor 12 including a voltage detection unit for detecting a terminal voltage of the battery. In this state, the open circuit voltage of the battery 11 is detected.

The processor 12 further indudes a judgment unit, such as a judging circuit, for comparing the detected voltage value with predetermined voltages x, y and z satisfying x<y<z, and determining in which of following voltage regions as shown in Fig. 3 the detected value falls: the voltage region K of smaller than the predetermined voltage x, the voltage region L of equal to or greater than the predetermined voltage x or smaller than the predetermined voltage z, the voltage region M of equal to or greater than the predetermined voltage z or smaller than the predetermined voltage y, and the voltage region N of equal to or greater than the predetermined voltage y.

The processor 12 further indudes a control unit for controlling the charging circuit 14 and the switching unit 16 on the basis of the judgment of the judgment unit.

An input circuit (not shown) in the charging circuit 14 and an external power supply 15 form a dosed circuit. During the charging of the secondary battery 11, an output circuit (not shown) in the charging circuit 14 and the secondary battery 11 form a dosed circuit by an action of the switching circuit 16. At this time, the voltage detection unit detects a dosed circuit voltage of the battery 11. The external power supply 15 may be replaced with an internal power supply mounted in the charger.

The charging circuit 14 can perform constant-current charging and constant-voltage charging in a switchable manner. Further, the charging circuit 14 can perform the constant-current charging with a charge current being switched stepwise. Specifically, the current value is switchable among comparatively small current values B and C and a comparatively great current value A. The current values B and C may be each set to 10 to 60% of the current value A. The current values B and C may be different from each other or the same. The switching between constant-current charging and constant-voltage charging, the switching of the charge current, and the like are controlled by the control unit, on the basis of the judgment of the judgment unit.

The charging circuit 14 is communicated with the above-described processor 12 including the voltage detection unit, judgment unit, and control unit. The judgment unit and the control unit may be included in the charging circuit 14. In this configuration, the information on the detected voltage value is transmitted from the processor 12 to the charging circuit 14.

The negative electrode of the battery 11 and the negative electrode terminal of the input circuit in the charging circuit 14 each have the same potential as the negative electrode terminal of the external power supply 15. The positive electrode of the battery 11 and the positive electrode terminal of the output circuit in the charging circuit 14 are connected to predetermined terminals 17 and 19, respectively, included in the switching circuit 16.

The switching circuit 16 includes a charge switch for controlling the connection between the positive electrode of the secondary battery 11 and the positive electrode terminal of the output circuit in the charging circuit 14. When the charge switch is tumed on, the positive electrode of the secondary battery 11 and the positive electrode terminal of the output circuit in the charging circuit 14 are connected to each other, and when the charge switch is tumed off, the connection is broken.

The switching circuit 16 is communicated with the above-described processor 12 including the voltage detection unit, judgment unit, and control unit. The switching circuit 16 is controlled by the control unit, on the basis of the judgment of the judgment unit.

When the charge switch in the switching circuit 16 is tumed on, and the positive electrode of the secondary battery 11 and the positive electrode terminal of the output circuit in the charging circuit 14 are connected to each other, the charging unit 14 starts charging the secondary battery 11 according to the instruction from the processor 12. The dosed circuit voltage of the secondary battery 11 while being charged is monitored by the processor 12. Alternatively, when the charging circuit 14 indudes the judgment unit, the dosed circuit voltage of the secondary battery 11 while being charged is monitored by the charging circuit 14.

Among the voltage detection unit, judgment unit, and control unit in the processor 12, only the control unit may be included in the charging circuit 14. In this configuration, necessary information is input to the control unit from the judgment unit and the like in the processor 12.
The processor, voltage detection unit, judgment unit, and control unit may be configured with a microcomputer, a wired logic circuit, or the like.

The battery 11 may be a lithium ion secondary battery using a lithium-containing composite oxide as a positive electrode active material, and a carbonaceous material capable of charging and discharging lithium ions as a negative electrode active material.

The lithium-containing composite oxide may be a composite oxide containing lithium and nickel. The composite oxide preferably has a cubic closest-packed structure of oxygen. The molar ratio of Ni to Li in the composite oxide is preferably 90 mol% or less and more preferably 30 to 90 mol%. When the molar ratio of Ni to Li exceeds 90 mol%, the crystal structure of the positive electrode becomes unstable, and deterioration of the positive electrode active material and degradation in safety become more likely to occur.

The composite oxide containing lithium and nickel preferably further contains at least one selected from the group consisting of aluminum, manganese and cobalt. In such a composite oxide, the molar ratio of AI to Li is preferably 1 to 10 mol%, the molar ratio of Mn to Li is preferably 10 to 70 mol%, and the molar ratio of Co to Li is preferably 10 to 70 mol%. The positive electrode active material having such a composition has a high energy density as well as is highly stable.

A preferred composite oxide has a composition represented by, for example, the formula (1):

Li[Liₚ(NiₘMₙ)₁₋ₚ]O₂,

where, m is an atomic ratio of nickel; M is at least one selected from the group consisting of aluminum, manganese and cobalt; n is an atomic ratio of M; m+n=1; 0p≤0≤0.1 ; 0.3≤m≤0.9; and 0.1≤n≤0.7.

Examples of the carbonaceous material used as the negative electrode active material include graphite, graphitizable carbon, non-graphitizable carbon, and carbon fibers. Examples of the graphite include various artificial graphites and various natural graphites.

Next, one example of carrying out the charging method of the present invention with the charger as shown in Fig. 2 is described below with reference to the flowchart of Fig. 1.
First, the secondary battery 11 is set on the charger (S0). Upon setting, while the charge switch in the switching circuit 16 is tumed off, the voltage detection unit in the processor 12 detects an open circuit voltage of the battery 11.

Secondly, the judgment unit in the processor 12 compares the detected open-circuit voltage (OCV) with a predetermined voltage x (S1). Here, the predetermined voltage x is a voltage corresponding to a comparative low state of charge (the predetermined value X) of the battery 11. For example, the predetermined voltage x is a voltage corresponding to a state of charge of 5 to 30%.

When the comparison result is OCV<x, the battery 11 is nearly in a fully discharged state. When OCV<x, the processor 12 turns on the charge switch in the switching circuit 16, and sets the output from the charging circuit 14 such that charging is performed at a comparatively small current value B (S2).
When OCV≥x, the judgment unit in the processor 12 further compares the detected value (OCV) with a predetermined voltage z (S3). Here, the predetermined voltage z is a voltage corresponding to a comparatively high state of charge (the predetermined value Z) of the battery 11. For example, the predetermined voltage z is a voltage corresponding to a state of charge of 65 to 90%.

When the comparison result is OCV<z, namely, x≤OCV<z, the battery 11 is in a half charged state. When OCV<z, the processor 12 sets the output from the charging circuit 14 such that charging is performed at a comparatively great current value A satisfying A>B (S4).

When OCV≥z, the judgment unit in the processor 12 further compares the detected value (OCV) with a predetermined voltage y (S5). Here, the predetermined voltage y is a voltage corresponding to a battery voltage in a fully charged state or a state of charge of the battery 11 at which charging should be switched to constant-voltage charging (the predetermined value Y). The predetermined voltage y is preferably a voltage within ±0.05 V of a recommended charge cutoff voltage of secondary batteries. Further, the predetermined voltage y may be a voltage within ±1 % of a nominal voltage of secondary batteries.

When the comparison result is OCV≥y, the battery 11 is regarded as fully charged, and no charging is performed (S6).
When OCV<y, namely, z≤OCV<y, the state of charge of the secondary battery 11 is comparatively high. When OCV<y, charging is performed at a current value C satisfying C<A (S7).

During the charging at the current value B (S2), at the time when a predetermined period of time has passed from the start of the charging, the dosed circuit voltage (CCV) of the secondary battery 11 is measured, and compared with the predetermined voltage x (S8). When the CCV is below the predetermined voltage x, the charging at the current value B is continued (S2). When the CCV is or exceeds the predetermined voltage x, the charging is switched to a charging at the current value A (S4). The step S8 is repeated every time when the predetermined period of time has passed, until the CCV reaches the predetermined voltage x. It should be noted that the predetermined voltage x to be compared with the OCV may be different from that to be compared with the CCV.

During the charging at the current value A (S4), at the time when a predetermined period of time has passed from the start of the charting, the dosed circuit voltage (CCV) of the battery 11 is measured, and compared with the predetermined voltage z (S9). When the CCV is below the predetermined voltage z, the charging at the current value A is continued (S4). When the CCV is or exceeds the predetermined voltage z, the charging is switched to a charging at the current value C (S7). The step S9 is repeated every time when the predetermined period of time has passed, until the CCV reaches the predetermined voltage z. It should be noted that the predetermined voltage z to be compared with the OCV may be different from that to be compared with the CCV.

During the charging at the current value C (S7), at the time when a predetermined period of time has passed from the start of the charting, the dosed circuit voltage (CCV) of the secondary battery 11 is measured, and compared with the predetermined voltage y (S10). When the CCV is below the predetermined voltage y, the charging at the current value C is continued (S7). When the CCV is or exceeds the predetermined voltage y, the charging is switched to a predetermined constant-voltage charging (S11). The step S10 is repeated every time when the predetermined period of time has passed, until the CCV reaches the predetermined voltage y. It should be noted that the predetermined voltage y to be compared with the OCV may be different from that to be compared with the CCV.

When the constant-voltage charging is completed, the secondary battery 11 is regarded as fully charged, and the charging is terminated (S6).

Fig. 4 shows, in the form of a graph, the relationship between a state of charge, and a battery voltage and a charge current, when the battery is charged by following the procedures shown in Fig. 1.

In Fig. 4, a secondary battery is charged from when the battery voltage E is 3.2 V (a fully discharged state) to when it reaches 4.2 V (a full state of charge). In this charging, constant-current charging is performed until the state of charge (SOC) reaches about 90%, after which constant-voltage charging is performed.
In the constant-current charging, the charge current (current CA) is changed in three stages.

Specifically, in the range where the state of charge is lower than 15% (the predetermined value X), the current CA is 0.4 C (the current value B); in the range where the state of charge is 15% or higher and lower than 76% (the predetermined value Z), the current CA is 0.8 C (the current value A); and in the range where the state of charge is 76% or higher and lower than 90% (the predetermined value Y), the current CA is 0.4 C (the current value C). In the range where the state of charge is 90% or higher, the charge voltage is kept constant (4.2 V), and the current CA reduces (the constant-voltage charging).

Here, the current values 0.4 C and 0.8C are current values 0.4 times and 0.8 times as great as the theoretical current value (1.0 C) at which the rated capacity of the secondary battery can be charged in one hour, respectively. For example, provided that the rated capacity of the secondary battery is 2000 mAh, 1.0 C, 0.4 C and 0.8 C correspond to 2000 mAh, 800 mAh and 1600 mAh, respectively.

Fig. 4 also shows how the intemal resistance R of the secondary battery varies as the state of charge varies. Here, the intemal resistance R is measured by the GITT method.
In the measurement of resistance R by the GITT method, a secondary battery is charged at a comparatively small current for a predetermined period of time, followed by an interval of charging for a predetermined period of time, and the charging and interval are repeated.

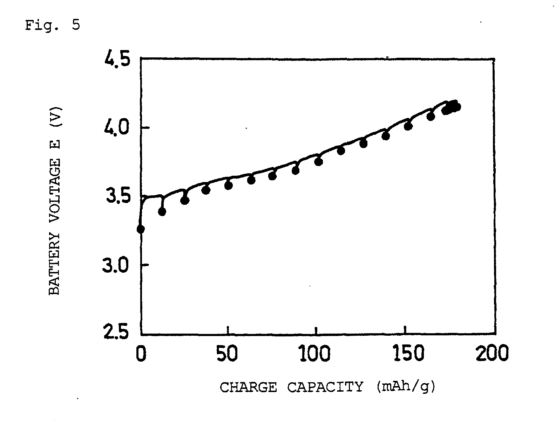

Fig. 5 shows how the battery voltage (dosed circuit voltage) varies when a secondary battery having a capacity of 1000 mAh is charged at a current of 0.2 C (200 mA) for 20 minutes in a 25°C environment, followed by an interval of charging for 30 minutes, and the charging and interval are repeated. In the graph, each black dot represents an open circuit voltage of the secondary battery measured at the end of the interval of charging and immediately before resuming the charging.

The measurement of resistance R by the GITT method is specifically performed as follows.
After the open circuit voltage of the secondary battery has been measured at the end of each interval of charging as described above, the impedance of the secondary battery is measured within the frequency range of 100 kHz to 0.01 Hz. From the impedance spectrum obtained by the above measurement, the liquid resistance, film resistance, and electric charge transfer resistance of the secondary battery are determined. A total of these resistances is calculated as an internal resistance R.

The internal resistance R of the battery 11 measured as described above is extremely high when the battery 11 is nearly in a fully discharged state, and then drops sharply as the state of charge becomes high. When the state of charge reaches about 15%, the internal resistance R drops to a value very dose to the minimum value (0.15 Ω).

As described above, the battery 11 has a very high intemal resistance when being nearly in a fully discharged state. The more nearly the battery is in a fully discharged state, the more the charge polarization is increased when such a battery is charged at a constant current, because the charge polarization is proportional to the charge voltage. As a result, charging irregularity (non-uniform charging) occurs, which in tum causes, for example, an anisotropic expansion in the negative electrode active material layer. This results in a separation of the SEI from the negative electrode, decomposition of the electrolyte, generation of reducing gas inside the battery, and other troubles. Consequently, the cyde characteristics of the non-aqueous electrolyte secondary battery deteriorate.

In order to prevent these troubles, in the method shown in Fig. 1, the battery 11 is charged at the comparatively small current value B in the range where the battery 11 is nearly in a fully discharged state (i.e., the range smaller than the predetermined value X) to suppress the increase in the charge polarization. Then, the battery 11 is charged at the comparatively great current value A, when the battery is in a half charged state in which the internal resistance is small. By charging in such a manner, it is possible to prevent an anisotropic expansion in the negative electrode of the battery, separation of the SEI from the negative electrode, decomposition of electrolyte, generation of reducing gas inside the battery, and other troubles. Consequently, the cyde characteristics of the non-aqueous electrolyte secondary battery can be improved.

As described above, the predetermined value X is preferably set at a state of charge of 5 to 30%. When the predetermined value X is set at a state of charge of lower than 5%, the charge current may be switched to the comparatively great current value A, before the internal resistance of the secondary battery drops to a sufficient level. When this happens, the variation in charge polarization cannot be minimized sufficient, and the cyde characteristics cannot be improved sufficiently. When the predetermined value X is set at a state of charge of 30% or higher, the timing at which the charge current is switched to the comparatively great current value A is delayed, resulting in a longer charging time. As such, by setting the predetermined value X appropriately at a value within the range of 5 to 30%, it is possible to significantly improve the cyde characteristics of the secondary battery, without increasing the charging time.

The current value B is preferably 10 to 60% of the current value A. When the current value B exceeds 60% of the current value A, the variation in charge polarization may not be sufficiently minimized. When this happens, the cyde characteristics cannot be improved sufficiently. When the current value B is less than 10% of the current value A, the charge current is too small, resulting in a longer charging time.

In addition, as shown in Fig. 4, the intemal resistance R of the secondary battery 11 turns to increase again when the state of charge reaches a certain level or higher. Because of this, in the example shown in Fig. 4, the charge current is switched again to the comparatively small current value C when the state of charge reaches 76% (the predetermined value Z).

The predetermined value Z is preferably set at a state of charge of 65 to 90%. When the predetermined value Z is higher than a state of charge of 90%, the variation in charge polarization may not be minimized sufficiently. When this happens, the cyde characteristics cannot be improved sufficiently. When the predetermined value Z is lower than a state of charge of 65%, the timing at which the charge current is switched to the comparatively small current value C is advanced, resulting in a longer charging time. As such, by setting the predetermined value Z at a state of charge of 65 to 90%, it is possible to significantly improve the cyde characteristics of the secondary battery, as well as to charge the secondary battery for a comparative short charging time.

The current value C is preferably 10 to 60% of the current value A. When the current value C exceeds 60% of the current value A, the variation in charge polarization may not be sufficiently minimized. When this happens, the cycle characteristics cannot be improved sufficiently. When the current value C is less than 10% of the current value A, the charge current is too small, resulting in a longer charging time.

The charging as described above makes it possible to prevent the charge polarization from varying greatly with the change in the state of charge. This can improve the cyde characteristics of the secondary battery. In order to more completely suppress the variation in charge polarization, it is ideal to adjust the charge current as indicated by the curve CA_{T} in Fig. 4.

### (Embodiment 2)

Next, one example of simultaneously charging two or more non-aqueous electrolyte secondary batteries is described.

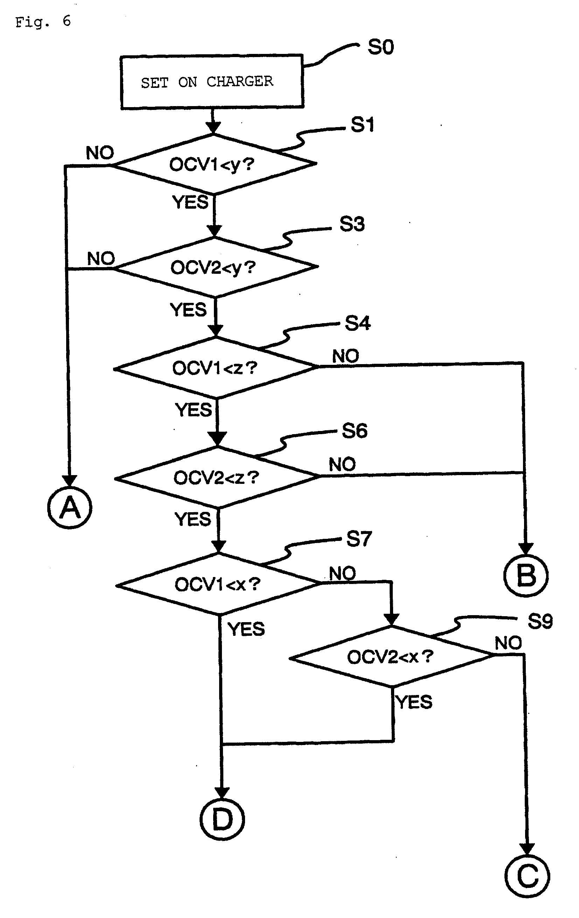

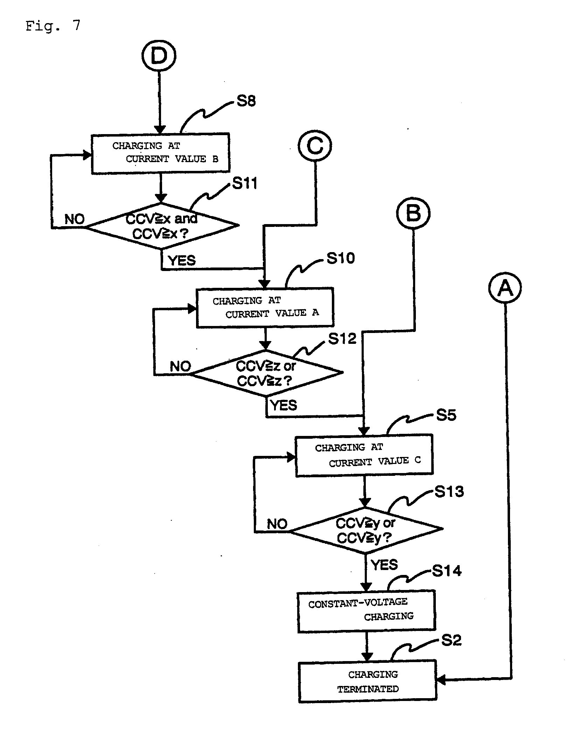

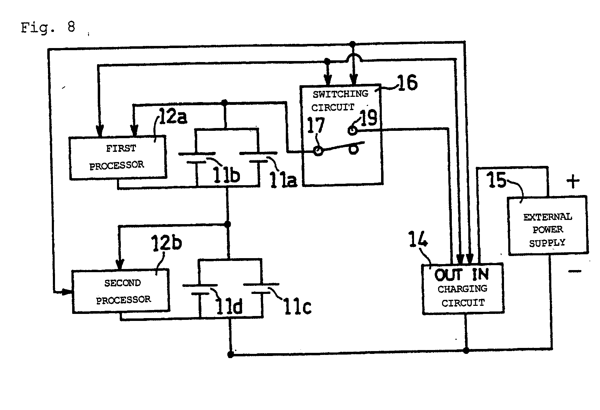

Figs. 6 and 7 are flowcharts for explaining a charging method for two or more non-aqueous electrolyte secondary batteries, and Fig. 8 is a block diagram of a charger. Here, the components having the same function as those in Fig. 2 are denoted by the same reference numerals as in Fig. 2.

This circuit represents a configuration used when a group of secondary batteries (two in parallel and two in series) are charged simultaneously. Two secondary batteries 11 a and 11 b connected in parallel are connected in parallel with a first processor 12a including a first voltage detection unit for detecting an open circuit voltage of these batteries. Similarly, two secondary batteries 11c c and 11d connected in parallel are connected in parallel with a second processor 12b induding a second voltage detection unit for detecting an open circuit voltage of these batteries.

A pair of the secondary batteries 11a and 11b and a pair of the secondary batteries 11c and 11d are connected to each other in series. The first and second processors include first and second judgment units, respectively, for determining in which of the voltage regions K, M, L and N each of the detected voltage values falls.

The first and second processors further include first and second control units, respectively, that cooperate with each other to control the charging circuit 14 and the switching unit 16, on the basis of the judgment of the first and second judgment units. One control unit may be provided in either only one of the first processor or the second processor. In this configuration, the judgment of the first and second judgment units is input into the one control unit.

Here, the two secondary batteries connected in parallel are collectively regarded as one secondary battery. In other words, in the present invention, two or more secondary batteries connected in parallel are handled as one secondary battery. This means that the present invention includes a charging method and a charger for charging two or more non-aqueous electrolyte secondary batteries connected in parallel, and does not exclude these.

Each of the first processor 12a and the second processor 12b is communicated with the charging circuit 14. Here, the judgment unit and the control unit may be included in the charging circuit 14. In this configuration, the detected voltage value is directly transmitted to the charging circuit 14. The circuit shown in Fig. 5 has the same configuration as in Fig. 2 except the above. Further, as in Embodiment 1, the charging circuit 14 may include the control unit only.

Next, another example of carrying out the charging method of the present invention with the charger as shown in Fig. 8 is described below with reference to the flowcharts of Figs. 6 and 7.
First, the secondary batteries 11 a to d are set on the charger (S0). Upon setting, while both the charge switch and the discharge switch in the switching circuit 16 are turned off, the first voltage detection unit in the first processor 12a measures an open circuit voltage of a parallel battery composed of the secondary batteries 11 a and 11 b, and the second voltage detection unit in the second processor 12b measures an open circuit voltage of a parallel battery composed of the secondary batteries 11c and 11d.

Secondly, the first judgment unit in the first processor 12a compares the detected value (OCV1) with a predetermined voltage y (S1). When the comparison result is OCV1≥y, the parallel battery composed of the secondary batteries 11a and 11b is regarded as having reached a full state of charge, and no charging is performed (S2).

When OCV1<y, the second judgment unit in the second processor 12b compares the detected value (OCV2) with the predetermined voltage y (S3). When the comparison result is OCV2≥y, the parallel battery composed of the secondary batteries 11 c and 11d is regarded as having reached a full state of charge, and no charging is performed (S2). In short, when at least one of OCV1≥y and OCV2≥y is satisfied, no charging is performed.

When OCV1<y and OCV2<y, the first judgment unit in the first processor 12a compares the detected value (OCV1) with a predetermined voltage z (S4). When OCV1≥z, namely, z≤OCV1 <y, the first processor 12a tums on the charge switch in the switching circuit 16, and sets the output from the charging circuit 14 such that each parallel battery is charged at a comparatively small current value C (S5).

When OCV1 <z, the second judgment unit in the second processor 12b further compares the detected value (OCV2) with the predetermined voltage z (S6). When the comparison result is OCV2≥z, namely, z≤OCV2<y, the second processor 12b tums on the charge switch in the switching circuit 16, and sets the output from the charging circuit 14 such that each parallel battery is charged at the comparatively small current value C (S5). In short, when at least one of z≤OCV1 <y and z≤OCV2<y is satisfied, charging is performed at the comparatively small current value C.

When OCV1<z and OCV2<z, the first judgment unit in the first processor 12a compares the detected value (OCV1) with a predetermined voltage x (S7). When OCV1<x, the first processor 12a tums on the charge switch in the switching circuit 16, and sets the output from the charging circuit 14 such that each parallel battery is charged at a comparatively small current value B(S8).

When OCV1≥x, namely, x≤OCV1 <z, the second judgment unit in the second processor 12b further compares the detected value (OCV2) with the predetermined voltage x (S9). When the comparison results is OCV2<x, the second processor 12b tums on the charge switch in the switching circuit 16, and sets the output from the charging circuit 14 such that each parallel battery is charged at the comparatively small current value B (S8). In short, when at least one of OCV1<x and OCV2<x is satisfied, charging is performed at the comparatively small current value B.

When OCV1≥x and OCV2≥x, namely, x≤OCV1<z and x≤OCV2<z, the first and second processors 12a and 12b tum on the charge switch in the switching circuit 16, and set the output from the charging circuit 14 such that each parallel battery is charged at the comparatively great current value A (S10). In short, only when both of the parallel batteries are in a half charged state, charging is performed at the comparatively great current value A.

During the charging at the current value B (S8), at the time when a predetermined period of time has passed from the start of the charging, the dosed circuit voltage (CCV) of each parallel battery is measured, and compared with the predetermined voltage x (S11). When either one of the CCVs of the parallel batteries is below the predetermined voltage x, the charging at the current value B is continued (S8). When both of the CCVs of the parallel batteries are or exceed the predetermined voltage x, the charging is switched to a charging at a current value A (S10). The step S11 is repeated every time when the predetermined period of time has passed, until both of the CCVs of the parallel batteries reach the predetermined voltage x.

During the charging at the current value A (S10), at the time when a predetermined period of time has passed from the start of the charging, the dosed circuit voltage (CCV) of each parallel battery is measured, and compared with the predetermined voltage z (S12). When both of the CCVs of the parallel batteries are below the predetermined voltage z, the charging at the current value A is continued (S10). When either one of the CCVs of the parallel batteries is or exceeds the predetermined voltage z, the charging is switched to a charging at a current value C (S5). The step S12 is repeated every time when the predetermined period of time has passed, until either one of the CCVs of the parallel batteries reaches the predetermined voltage z.

During the charging at the current value C (S5), at the time when a predetermined period of time has passed from the start of the charging, the dosed circuit voltage (CCV) of each parallel battery is measured, and compared with the predetermined voltage y (S13). When both of the CCVs of the parallel batteries are below the predetermined voltage y, the charging at the current value C is continued (S5). When either one of the CCVs of the parallel batteries is or exceeds the predetermined voltage y, the charging is switched to a predetermined constant-voltage charging (S14). The step S13 is repeated every time when the predetermined period of time has passed, until either one of the CCVs of the parallel batteries reaches the predetermined voltage y.

When the constant-voltage charging is completed, the secondary battery 11 is regarded as having reached a full state of charge, and the charging is terminated (S2).

Examples of the present invention are described below. However, the present invention is not limited to the following examples.

A lithium ion secondary battery was fabricated in the manner as described below.

### (Production of positive electrode plate)

In a reaction bath with a stirrer, 2 mol/L of aqueous nickel sulfate solution, 0.353 mol/L of aqueous cobalt sulfate solution, 5 mol/L of aqueous ammonium nitrate solution, and 10 mol/L of aqueous sodium hydroxide solution were put, and stirred with the stirrer. The resultant hydroxide was washed with water, and then dried and dehydrated, to prepare a nickel hydroxide represented by the composition formula Ni_{0.65}Co_{0.15}(OH)₂.

The nickel hydroxide obtained in the above was mixed with lithium hydroxide such that the atomic ratio of lithium:(nickel+cobalt) was 1.03:1, and baked at 750°C for 10 hours in an oxygen atmosphere, to synthesize LiNi_{0.85}COo_{0.15}O₂ as a positive electrode active material.

The positive electrode active material thus obtained was mixed with carbon black serving as a conductive agent, and an aqueous dispersion of polytetrafluoroethylene serving as a binder in a solid mass ratio of 100:3:10, and kneaded and dispersed. The resultant mixture was suspended in an aqueous solution of carboxymethylcellulose, to prepare a positive electrode material mixture paste. This positive electrode material mixture paste was applied onto both surfaces of a current collector made of a 30-µm-thick aluminum foil by a doctor blade method, such that the overall thickness thereof reached about 230 µm. Here, the overall thickness is a sum of the thicknesses of the current collector and the paste applied onto both surfaces of the current collector.

After having being dried, the current collector with paste was rolled to a thickness of 180 µm and cut into a predetermined size, to give a positive electrode plate. A positive electrode lead made of aluminum was welded to a portion of the current collector on which no positive electrode active material layer was formed.

### (Production of negative electrode plate)

Natural graphite serving as a negative electrode active material was mixed with a styrene-butadiene rubber binder in a mass ratio of 100:5, and kneaded and dispersed, to prepare a negative electrode material mixture paste. This negative electrode material mixture paste was applied onto both surfaces of a current collector made of a 20-µm-thick copper foil by a doctor blade method, such that the overall thickness thereof reached about 230 µm. Here, the overall thickness is the same as above. After having being dried, the current collector with paste was rolled to a thickness of 180 µm and cut into a predetermined size, to give a negative electrode plate. A negative electrode lead made of nickel was welded to a portion of the current collector on which no negative electrode active material layer was formed.

### (Preparation of non-aqueous electrolyte)

LiPF₆ was dissolved as a solute at a concentration of 1 mol/L in a mixed solvent obtained by mixing ethylene carbonate (EC) and diethyl carbonate (DEC) in a molar ratio of 1:3, to prepare a non-aqueous electrolyte.

### (Fabrication of battery)

The positive electrode plate and the negative electrode plate produced in the above were wound into a coil with a separator made of a 25-µm-thick polyethylene microporous film interposed therebetween, to form an electrode group. This electrode group was housed in a battery case, and after the non-aqueous electrolyte was injected into the battery case, the battery case was sealed, to yield a cylindrical lithium ion secondary battery.

The battery case was sealed by crimping the opening end of the battery case over a sealing body with an insulating gasket interposed therebetween, such that the compression rate of the sealing gasket reached 30%.
The battery thus obtained was 18.0 mm in diameter and 65.0 mm in overall height and had a capacity of 2000 mAh. In the same manner as described above, 30 lithium ion secondary batteries in total were fabricated.

### (Example 1)

With respect to 10 out of 30 lithium ion secondary batteries thus fabricated, 500 charge/discharge cydes were performed at 25°C.
In the charging, the batteries whose state of charge was 0% were subjected to constant-current and constant-voltage charging until the state of charge reached 100%. In this charging, when the battery voltage was within the range of 3.2 V or more and less than 3.5 V (i.e., when the state of charge was within the range of 0% or higher and lower than 30%), the batteries were charged at a constant current of 0.4 C (800 mA).

When the battery voltage was within the range of 3.5 V or more and less than 4.0 V (i.e., when the state of charge was within the range of 30% or higher and lower than 80%), the batteries were charged at a constant current of 0.8 C (1600 mA). When the battery voltage was within the range of 4.0 V or more and less than 4.2 V (i.e., when the state of charge was within the range of 80% or higher and lower than 100%), the batteries were charged at a constant current of 0.4 C (800 mA). After the battery voltage reached 4.2 V, the batteries were charged at a constant voltage of 4.2 V. When the charge current was reduced to 0.05 C, the constant-voltage charging was terminated.

In the discharging, the charged batteries were discharged at a constant current of 1.0 C (2000 mA), and when the battery voltage was reduced to 3.2 V, the discharging was terminated.

### (Comparative Example 1)

With respect to another 10 out of 30 lithium ion secondary batteries thus fabricated, 500 charge/discharge cydes were performed at 25°C.
In the charging, the batteries whose state of charge was 0% was subjected to constant-current and constant-voltage charging until the state of charge reached 100%. In this charging, the batteries were charged at a constant current of 0.7 C (1400 mA) until the battery voltage reached 4.2 V, and when the battery voltage reached 4.2 V, the charging was switched to a constant-voltage charging. The constant-voltage charging was performed until the charge current was reduced to 0.05 C. The discharging was performed in the same manner as in Example 1.

### (Comparative Example 2)

With respect to still another 10 out of 30 lithium ion secondary batteries thus fabricated, 500 charge/discharge cydes were performed at 25°C.
In the charging, the batteries whose state of charge was 0% were subjected to constant-current and constant-voltage charging until the state of charge reached 100%. In this charging, when the battery voltage was within the range of 3.2 V or more and less than 3.4 V (i.e., when the state of charge was within the range of 0% or higher and lower than 30%), the batteries were charged at a constant current of 0.8 C (1600 mA).

When the battery voltage was within the range of 3.5 V or more and less than 4.0 V (i.e., when the state of charge was within the range of 30% or higher and lower than 80%), the batteries were charged at a constant current of 0.4 C (800 mA). When the battery voltage was within the range of 4.0 V or more and less than 4.2 V (i.e., when the state of charge was within the range of 80% or higher and lower than 100%), the batteries were charged at a constant current of 0.8 C (1600 mA). After the battery voltage reached 4.2 V, the battery was charged at a constant voltage of 4.2 V. When the charge current was reduced to 0.05 C, the constant-voltage charging was terminated.

With respect to the 10 batteries of each of Example 1 and Comparative Examples 1 and 2, the capacity retention rate and the negative electrode expansion rate after the 500 charge/discharge cydes were measured.
The negative electrode expansion rate was measured as follows.

Ten secondary batteries were separately fabricated as reference batteries in the same manner as in Example 1. These reference batteries were disassembled after the charging at the 3rd cycle, to take out the negative electrode plates. The thicknesses of the negative electrode plates were measured with a micrometer. An average of the measured thicknesses was calculated as a negative electrode plate thickness of the reference battery. The 10 batteries of each of Example 1 and Comparative Examples 1 and 2 were disassembled after the charging at the 501th cycle, to take out the negative electrode plates. The thicknesses of the negative electrode plates were measured with a micrometer. The average of the measured thicknesses was calculated as a negative electrode plate thickness of each of Example 1 and Comparative Examples 1 and 2.

The difference between each of the negative electrode plate thicknesses of Example 1 and Comparative Examples 1 and 2, and the negative electrode thickness of the reference battery was calculated as an amount of expansion. The ratio of the amount of expansion of each example to the negative electrode thickness of the reference battery was calculated, to obtain a negative electrode expansion rate of each of Example 1 and Comparative Examples 1 and 2.
The results are shown in Table 1. The values in the table are of an average of 10 batteries.

**[Table 1]**

| | Capacity retention rate (%) | Negative electrode expansion rate (%) |
|---|---|---|
| Example 1 | 86 | 8 |
| Comparative Example 1 | 70 | 11 |
| Comparative Example 2 | 65 | 13 |

As shown in Table 1, Example 1 exhibited a higher capacity retention rate immediately after 500 charge/discharge cydes than Comparative Examples 1 and 2. This means that Example 1 had improved cyde characteristics.
In addition, Example 1 exhibited a smaller battery expansion rate immediately after 500 charge/discharge cydes than Comparative Examples 1 and 2. This is presumably a result of uniform charging in Example 1, which allowed the negative electrode active material to expand isotropically

The above results show that applying the present invention can improve the cyde characteristics of a lithium ion secondary battery.

Although the present invention has been described in terms of the presently preferred embodiments, it is to be understood that such disclosure is not to be interpreted as limiting. Various alterations and modifications will no doubt become apparent to those skilled in the art to which the present invention pertains, after having read the above disclosure. Accordingly, it is intended that the appended daims be interpreted as covering all alterations and modifications as fall within the true spirit and scope of the invention.

### [Industrial Applicability]

According to the charging method and charger of the present invention, the constant-current charging of a non-aqueous electrolyte secondary battery is performed in two or more stages, each at a different current value, and the current value in the first stage is set relatively small. This makes it possible to improve the cyde characteristics of the secondary battery. The charging method and charger of the present invention are particularly suitably applicable to the charging of a lithium ion secondary battery.

### [Reference Signs List]

- 11,11a, 11b,11c,11d: Secondary battery
- 12: Processor
- 12a: First processor
- 12b: Second processor
- 14: Charging circuit
- 15: External power supply
- 16: Switching circuit
- 17: Terminal
- 19: Terminal

## Claims

1. A charging method for a non-aqueous electrolyte secondary battery which comprises a positive electrode including a lithium-containing composite oxide as an active material, a negative electrode including a material capable of charging and discharging lithium ions as an active material, and a non-aqueous electrolyte, the charging method comprising the steps of:
(a) detecting a state of charge of the secondary battery;
(b) comparing the detected state of charge with a predetermined value X and a predetermined value Y satisfying Y>X; and
(c) on the basis of the comparison result,
(i) when the detected state of charge is equal to or higher than the predetermined value Y, performing constant-voltage charging or terminating charging,
(ii) when the detected state of charge is equal to or higher than the predetermined value X and lower than the predetermined value Y, performing constant-current charging at a current value A until the detected state of charge reaches a predetermined state of charge, and
(iii) when the detected state of charge is lower than the predetermined value X, performing constant-current charging at a current value B satisfying B<A.

2. The charging method for a non-aqueous electrolyte secondary battery in accordance with claim 1, further comprising
(d) comparing the detected state of charge with a predetermined value Z satisfying Y>Z>X, and
when the detected state of charge is equal to or higher than the predetermined value Z and lower than the predetermined value Y, performing constant-current charging at a current value C satisfying C<A.

3. The charging method for a non-aqueous electrolyte secondary battery in accordance with claim 1 or 2, wherein the step of detecting a state of charge includes a step of detecting an open circuit voltage or a dosed circuit voltage of the secondary battery.

4. The charging method for a non-aqueous electrolyte secondary battery in accordance with any one of daims 1 to 3, wherein the predetermined value X is a state of charge of 5 to 30%.

5. The charging method for a non-aqueous electrolyte secondary battery in accordance with any one of daims 2 to 4, wherein the predetermined value Z is a state of charge of 65 to 90%.

6. The charging method for a non-aqueous electrolyte secondary battery in accordance with any one of daims 1 to 5, wherein the current value B is 10 to 60% of the current value A.

7. The charging method for a non-aqueous electrolyte secondary battery in accordance with any one of daims 2 to 6, wherein the current value C is 10 to 60% of the current value A.

8. A charger for a non-aqueous electrolyte secondary battery which comprises a positive electrode including a lithium-containing composite oxide as an active material, a negative electrode including a material capable of charging and discharging lithium ions as an active material, and a non-aqueous electrolyte, the charger comprising:
a voltage detection unit for detecting a voltage of the secondary battery;
a state-of-charge detection unit for detecting a state of charge of the secondary battery on the basis of the detected voltage;
a current supply circuit for supplying a current from an external or internal DC power supply to the secondary battery with changing a value of the current stepwise;
a switch for switching an electrically connected state between the secondary battery and the current supply circuit;
a judgment unit for comparing the detected state of charge with a predetermined value X and a predetermined value Y satisfying Y>X, to make judgment on the detected state of charge; and
a control unit for controlling the switch and the current supply circuit on the basis of the judgment of the judgment unit, in such a manner that
(i) when the detected state of charge is equal to or higher than the predetermined value Y, performing constant-voltage charging or terminating charging,
(ii) when the detected state of charge is equal to or higher than the predetermined value X and lower than the predetermined value Y, performing constant-current charging at a current value A until the detected state of charge reaches a predetermined state of charge, and
(iii) when the detected state of charge is lower than the predetermined value X, performing constant-current charging at a current value B satisfying B<A.
